# EUROPEAN PATENT APPLICATION

(11) **EP 2 846 615 A1**
(43) Date of publication of application: **11.03.2015**
(21) Application number: 13780895.2
(22) Date of filing: 03.04.2013
(51) Int. Cl.: H05K 3/46, H01L 23/12, H01L 23/14

(54) **MULTILAYER WIRING SUBSTRATE AND MANUFACTURING METHOD THEREOF**

(30) Priority: 26.04.2012 JP 2012101905
(71) Applicant: NGK SPARK PLUG CO., LTD., Nagoya-shi, Aichi 467-8525 (JP)
(72) Inventor: MAEDA, Shinnosuke, Nagoya-shi Aichi 467-8525 (JP)
(74) Representative: Intès, Didier Gérard André
(86) International application number: PCT/JP2013/060190
(87) International publication number: WO 2013/161527

(57) **Abstract**

To provide a multilayer wiring board that ensures sufficient adhesion between a resin insulating layer and a conductor layer and is excellent in connection reliability.

The multilayer wiring board 10 has a multilayered build-up construction where a plurality of resin insulating layers 33 to 36 and a plurality of conductor layers 42 are alternately laminated. The resin insulating layers 33 to 36 are formed of the lower insulating layer 51 and the upper insulating layer 52 disposed on the lower insulating layer 51. The conductor layer 42 is formed on the surface of the upper insulating layer 52. The upper insulating layer 52 is formed thinner than the lower insulating layer 51. The silica filler occupying the upper insulating layer 52 has a lower volume proportion than the volume proportion of the silica filler and the glass cloth that are occupying the lower insulating layer 51.

## Description

### TECHNICAL FIELD

The present invention relates to a multilayer wiring board with a multilayered build-up construction where a plurality of resin insulating layers and a plurality of conductor layers are alternately laminated, and to a method for manufacturing the multilayer wiring board.

### BACKGROUND ART

Nowadays, in association with downsizing of electrical devices, electronic devices, and similar device, multilayer wiring boards and similar member to be mounted on these devices are required to be compact or made highly dense. As this multilayer wiring board, a wiring board manufactured by what is called a build-up method has been put into practice. In the build-up method, a plurality of resin insulating layers and a plurality of conductor layers are alternately laminated to integrate. In the multilayer wiring board in this type, a wiring board with resin insulating layers with addition of silica filler has been put into practice, in order to improve adhesion between the resin insulating layers and the conductor layers, which are formed on the resin insulating layers by plating, or in order to decrease the coefficient of thermal expansion, or similar purpose (for example, see Patent Document 1).

Patent Document 1: JP-A-2012-44158

### DISCLOSURE OF THE INVENTION

### PROBLEMS TO BE SOLVED BY THE INVENTION

Now, in order to manufacture a multilayer wiring board with little warping by reducing the thermal expansion coefficient of the resin insulating layers, it is preferred that the grain diameter of the silica filler be decreased so as to increase the volume proportion of the silica filler occupying the resin insulating layers. However, decreasing the grain diameter of the silica filler does not allow obtaining a sufficient surface roughness even if roughening treatment is performed on the surface of the resin insulating layer. This decreases the adhesion strength of the conductor layers secured by an anchor effect.

The present invention has been made in view of the above-described circumstances, and it is an object of the present invention to provide a multilayer wiring board that ensures sufficient adhesion between the resin insulating layers and conductor layers and is excellent in connection reliability. Another object is to provide an appropriate method for manufacturing a multilayer wiring board to manufacture the above-described multilayer wiring board.

### SOLUTIONS TO THE PROBLEMS

A means for solving the above problems (Means 1) is a multilayer wiring board with a multilayered build-up construction where a plurality of resin insulating layers and a plurality of conductor layers are alternately laminated. In this multilayer wiring board, at least one resin insulating layer among the plurality of resin insulating layers is formed of a lower insulating layer and an upper insulating layer. The upper insulating layer is disposed on the lower insulating layer. The upper insulating layer has a surface on which the conductor layer is formed. The upper insulating layer and the lower insulating layer each contain an inorganic material in a resin insulating material. The upper insulating layer is formed thinner than the lower insulating layer. The inorganic material occupying the upper insulating layer has a lower volume proportion than a volume proportion of the inorganic material occupying the lower insulating layer.

According to the invention described in Means 1, at least one resin insulating layer among the plurality of resin insulating layers constituting the multilayer wiring board is formed of the lower insulating layer and the upper insulating layer. This upper insulating layer in the resin insulating layer has a low volume proportion of the inorganic material. Accordingly, performing roughening treatment on the surface of the upper insulating layer ensures a comparatively large surface roughness. In this case, this ensures sufficient adhesion strength of the conductor layer formed on the upper insulating layer. The lower insulating layer in the resin insulating layer is formed thicker than the upper insulating layer, and has a high volume proportion of the inorganic material. This ensures a reduced thermal expansion coefficient of the resin insulating layer so as to manufacture the multilayer wiring board with little warpage and excellent connection reliability.

The shapes of the inorganic materials contained in the upper insulating layer and the lower insulating layer are not specifically limited. For example, the upper insulating layer and the lower insulating layer may both contain a granular inorganic material. The granular inorganic material in the upper insulating layer may have an average grain diameter that is the same as or larger than an average grain diameter of the granular inorganic material in the lower insulating layer. Especially, providing the larger average grain diameter of the inorganic material in the upper insulating layer than that of the lower insulating layer ensures the increased surface roughness of the upper insulating layer. Additionally, decreasing the grain diameter of the inorganic material in the lower insulating layer allow the lower insulating layer to contain an increased amount of the inorganic material. In this case, the thermal expansion coefficient of the lower insulating layer is smaller than the thermal expansion coefficient of the upper insulating layer. Accordingly, decreasing the thermal expansion coefficient of the lower insulating layer, which is comparatively thick, decreases the thermal expansion coefficient of the overall resin insulating layer, thus warping of the multilayer wiring board is reduced.

In the multilayer wiring board according to Means 1, the conductor layer may be buried only in the lower insulating layer among the upper insulating layer and the lower insulating layer that constitute the resin insulating layer. Accordingly, the conductor layer is buried only in the lower insulating layer with the smaller thermal expansion coefficient than that of the upper insulating layer. This relieves the stress generated by the difference in thermal expansion coefficient between the conductor layer and the resin insulating layer.

The multilayer wiring board according to Means 1 may further include a via conductor formed by penetrating the resin insulating layer. The via conductor may have a larger contact area with the lower insulating layer than a contact area with the upper insulating layer. This ensures an increased contact area between the via conductor and the lower insulating layer, which has a smaller thermal expansion coefficient than that of the upper insulating layer, thus the stress on an inner wall surface of a via hole in contact with the via conductor is relieved.

The lower insulating layer may contain both a granular inorganic material and a fiber-like inorganic material as the inorganic material while the upper insulating layer contains a granular inorganic material alone as the inorganic material. This ensures a lower volume proportion of the inorganic material occupying the upper insulating layer than the volume proportion of the inorganic material occupying the lower insulating layer. Additionally, containing the fiber-like inorganic material in the lower insulating layer increases the strength of the resin insulating layer. Furthermore, in the case where the fiber-like inorganic material is disposed approximately in the center of the lower insulating layer in the thickness direction, the lower insulating layer reliably contains the inorganic material without exposure of the fiber-like inorganic material from the surface of the lower insulating layer.

Any of an insulating material and a conductive material is possible as the inorganic material. However, use of an insulating inorganic material keeps satisfactory electricity property of the multilayer wiring board. Specifically, the granular inorganic material can employ a silica filler. The fiber-like inorganic material can employ a glass cloth. In the case where the inorganic material employs the silica filler, the lower insulating layer may contain the silica filler in a proportion of 60 weight% or more, and the upper insulating layer may contain the silica filler in a proportion of 45 weight% or less. Especially, in the case where the lower insulating layer contains the silica filler and the glass cloth as the inorganic material, these inorganic materials may be contained in a proportion of 80 weight% or more. This ensures sufficient adhesion strength of the conductor layer on the resin insulating layer while decreasing the thermal expansion coefficient of the resin insulating layer.

The average grain diameter of the granular inorganic material in the upper insulating layer may be smaller than the thickness of the upper insulating layer, specifically, an average grain diameter equal to or less than about 1/5 of the thickness of the upper insulating layer. In this case, the upper insulating layer reliably contains the granular inorganic material.

The thickness of each insulating layer is not specifically limited insofar as the upper insulating layer is formed thinner than the lower insulating layer. For example, the upper insulating layer may be formed to have a thickness equal to or less than 1/3 of the lower insulating layer. Specifically, the thickness of the upper insulating layer may be equal to or more than 5 µm and less than or equal to 10 µm. The thickness of the lower insulating layer may be equal to or more than 20 µm. This ensures adhesion between the upper insulating layer and the conductor layer without forming a thicker upper insulating layer than necessary.

The upper insulating layer and the lower insulating layer are each formed by using a sheet-shaped build-up material. The resin insulating material that constitutes this build-up material can be selected as necessary in consideration of insulation property, heat resistance, humidity resistance, and similar property. Preferable examples of the resin insulating material include thermosetting resin such as epoxy resin, phenolic resin, urethane resin, silicone resin, and polyimide resin, thermoplastic resin such as polycarbonate resin, acrylic resin, polyacetal resin, and polypropylene resin, and similar resin.

Another means for solving the above problems (Means 2) is a method for manufacturing a multilayer wiring board with a multilayered build-up construction where a plurality of resin insulating layers and a plurality of conductor layers are alternately laminated. The method includes a preparation step, a lamination step, a roughening step, and a conductor-layer forming step. The preparation step prepares a lower insulating layer and an upper insulating layer. The lower insulating layer and the upper insulating layer form at least one resin insulating layer among the plurality of resin insulating layers. The lamination step laminates the upper insulating layer on the lower insulating layer. The roughening step performs roughening treatment on a surface of the upper insulating layer. The conductor-layer forming step forms the conductor layer on the roughened surface of the upper insulating layer. The upper insulating layer and the lower insulating layer contain an inorganic material in a resin insulating material. The inorganic material occupying the upper insulating layer has a lower volume proportion than a volume proportion of the inorganic material occupying the lower insulating layer.

Therefore, according to the invention described in Means 2, in the preparation step, the lower insulating layer and the upper insulating layer to form one resin insulating layer are prepared. In the lamination step, the upper insulating layer is laminated on the lower insulating layer. This upper insulating layer has a low volume proportion of the inorganic material. Accordingly, performing the roughening treatment on the surface of the upper insulating layer in the roughening step ensures a comparatively large surface roughness of the upper insulating layer. Subsequently, in the conductor-layer forming step, the conductor layer is formed on the roughened surface of the upper insulating layer. This ensures sufficient adhesion strength of the conductor layer on the surface of the upper insulating layer. Additionally, the lower insulating layer to form the resin insulating layer has a high volume proportion of the inorganic material. This ensures a reduced thermal expansion coefficient of the resin insulating layer. Consequently, a multilayer wiring board with little warpage and excellent connection reliability can be manufactured.

### BRIEF DESCRIPTION OF THE DRAWINGS

Fig. 1 is a sectional view illustrating a schematic configuration of the multilayer wiring board in this embodiment.
Fig. 2 is an enlarged sectional view illustrating a configuration of a resin insulating layer.
Fig. 3 is an explanatory view illustrating a manufacturing process for forming a core substrate in a method for manufacturing the multilayer wiring board.
Fig. 4 is an explanatory view illustrating a preparation step in the method for manufacturing the multilayer wiring board.
Fig. 5 is an explanatory view illustrating a lamination step in the method for manufacturing the multilayer wiring board.
Fig. 6 is an explanatory view illustrating a manufacturing process for forming a via hole in the method for manufacturing the multilayer wiring board.
Fig. 7 is an explanatory view illustrating a conductor-layer forming step in the method for manufacturing the multilayer wiring board.
Fig. 8 is an explanatory view illustrating a build-up step in the method for manufacturing the multilayer wiring board.
Fig. 9 is a schematic diagram illustrating a SEM photograph of a cross-section of an upper insulating layer.
Fig. 10 is a sectional view illustrating a schematic configuration of a multilayer wiring board in another embodiment.

### DESCRIPTION OF EMBODIMENTS

Hereinafter, a description will be given of one embodiment where the present invention is embodied in a multilayer wiring board in detail based on the drawings.

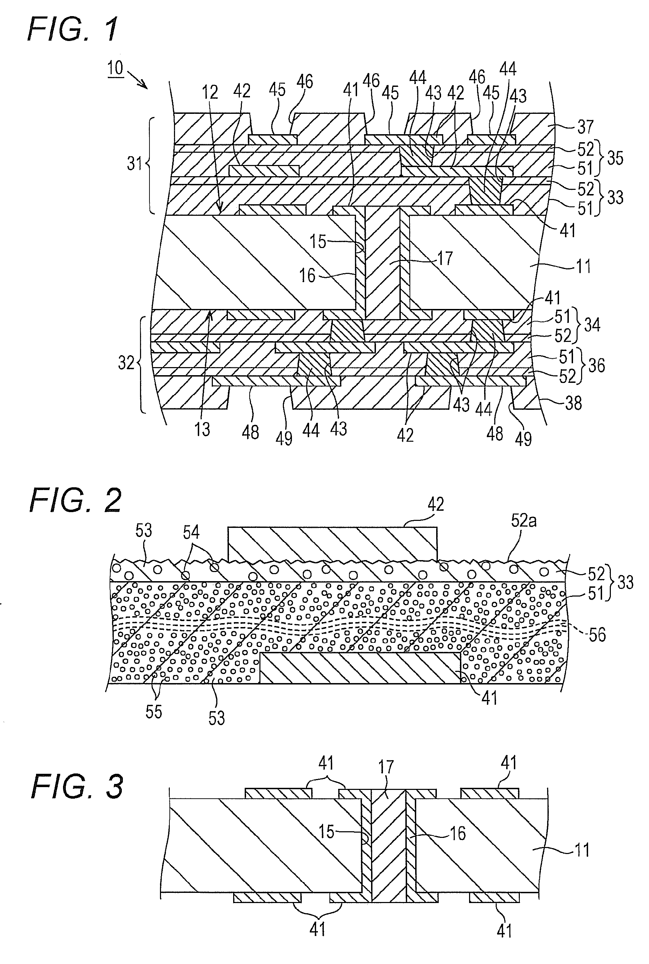

As illustrated in Fig. 1, a multilayer wiring board 10 according to this embodiment includes a core substrate 11, a first build-up layer 31, and a second build-up layer 32. The first build-up layer 31 is formed on a core main surface 12 (the top surface in Fig. 1) of the core substrate 11. The second build-up layer 32 is formed on a core reverse surface 13 (an inferior surface in Fig. 1) of the core substrate 11.

The core substrate 11 is constituted of, for example, resin insulating material (glass epoxy material) where epoxy resin is impregnated into a glass cloth as reinforcement material. In a plurality of portions in the core substrate 11, through-hole-purpose holes 15 (penetration hole) penetrating in the thickness direction are formed. Within the through-hole-purpose hole 15, a through-hole conductor 16 is formed. The through-hole conductor 16 connects the core main surface 12 side and the core reverse surface 13 side of the core substrate 11. The interior of the through-hole conductor 16 is filled with a blocking body 17 such as epoxy resin. On the core main surface 12 and the core reverse surface 13 of the core substrate 11, conductor layers 41 made of copper are patterned. Each conductor layer 41 electrically connects to the through-hole conductor 16.

The first build-up layer 31 formed on the core main surface 12 of the core substrate 11 has a build-up construction where a plurality of resin insulating layers 33 and 35 and a plurality of conductor layers 42 made of copper are alternately laminated. In a plurality of portions on the resin insulating layer 35, terminal pads 45 are formed in an array shape. Additionally, the top surface of the resin insulating layer 35 is almost entirely covered with a solder resist 37. In predetermined portions of the solder resist 37, opening portions 46 are formed to expose the terminal pads 45. The terminal pads 45 exposed from the opening portions 46 are electrically connected to connecting terminals of a semiconductor chip via solder bumps (not illustrated). Inside of the resin insulating layer 33 and the resin insulating layer 35, respective via holes 43 and respective via conductors 44 are formed. Each via conductor 44 electrically connects the conductor layers 41 and 42 and the terminal pad 45 to one another.

The second build-up layer 32 formed on the core reverse surface 13 of the core substrate 11 has approximately the same construction as that of the above-described first build-up layer 31. That is, the second build-up layer 32 has a build-up construction where a plurality of resin insulating layers 34 and 36 and a plurality of conductor layers 42 are alternately laminated. Inside of the resin insulating layer 34 and the resin insulating layer 36, the respective via holes 43 and the respective via conductors 44 are formed. In a plurality of portions on the inferior surface of the resin insulating layer 36, BGA pads 48 are formed in an array shape. The inferior surface of the resin insulating layer 36 is almost entirely covered with a solder resist 38. In predetermined portions of the solder resist 38, opening portions 49 are formed to expose the BGA pads 48. The BGA pads 48 exposed from the opening portions 49 are electrically connected to a mother board (an external board) via solder bumps (not illustrated).

As illustrated in Fig. 2, each of the resin insulating layers 33 to 36 that constitute the build-up layers 31 and 32 includes a lower insulating layer 51 and an upper insulating layer 52 disposed on the lower insulating layer 51. The upper insulating layer 52 has a surface on which the conductor layer 42 is formed. The upper insulating layer 52 is formed thinner than the lower insulating layer 51. Specifically, the upper insulating layer 52 has a thickness equal to or more than 5 µm and less than or equal to 10 µm (a thickness of, for example, about 8 µm in this embodiment). The lower insulating layer 51 has a thickness equal to or more than 20 µm (a thickness of, for example, about 30 µm in this embodiment). That is, in this embodiment, the upper insulating layer 52 has a thickness equal to or less than 1/3 of the thickness of the lower insulating layer 51.

The lower insulating layer 51 and the upper insulating layer 52 are both formed to contain insulating inorganic material. The volume proportion of the inorganic material occupying the upper insulating layer 52 is lower than the volume proportion of the inorganic material occupying the lower insulating layer 51.

For more details, the upper insulating layer 52 is formed by using a sheet-shaped build-up material constituted to contain a silica filler 54 (granular inorganic material) inside of a resin insulating material 53 (for example, thermosetting epoxy resin). The silica filler 54 contained in the upper insulating layer 52 is a filler with an average grain diameter of 1.0 µm. In the upper insulating layer 52, the proportion of the silica filler 54 inside of the resin insulating material 53 is about 40 weight%.

On the other hand, the lower insulating layer 51 is formed by using a sheet-shaped build-up material constituted to contain a silica filler 55 (granular inorganic material) and a glass cloth 56 (fiber-like inorganic material) inside of the resin insulating material 53. The silica filler 55 contained in the lower insulating layer 51 is a filler with an average grain diameter of 0.5 µm. In this embodiment, the lower insulating layer 51 contains the silica filler 55 with a smaller average grain diameter than that of the silica filler 54 of the upper insulating layer 52. The silica filler 55 occupying the lower insulating layer 51 has a higher volume proportion than the volume proportion of the silica filler 54 occupying the upper insulating layer 52. Specifically, in the lower insulating layer 51, the proportion of the silica filler 55 in the resin insulating material 53 is about 65 weight%. The glass cloth 56 has a thickness of, for example, about 15 µm. The glass cloth 56 is disposed approximately in the center of the lower insulating layer 51 in the thickness direction. In the lower insulating layer 51, the proportion of the inorganic material including the glass cloth 56 and the silica filler 55 is about 90 weight%.

The lower insulating layer 51 contains the inorganic material in an increased amount than that of the upper insulating layer 52. Accordingly, the lower insulating layer 51 has a smaller thermal expansion coefficient than the thermal expansion coefficient of the upper insulating layer 52. Specifically, regarding the thermal expansion coefficient in planar direction (the XY direction), the lower insulating layer 51 has approximately 20 ppm/°C while the upper insulating layer 52 has approximately 45 ppm/°C. The thermal expansion coefficient means the mean value of measured values at between 25°C and 150°C. The lower insulating layer 51 with the small thermal expansion coefficient is formed thicker than the upper insulating layer 52, so as to lower the thermal expansion coefficient as the overall insulating layer.

The upper insulating layers 52 of the resin insulating layers 33 to 36 each contain the silica filler 54 with a large grain diameter, and each have a surface that is a rough surface 52a with a large surface roughness. In these resin insulating layers 33 to 36, the conductor layers 42 are formed on the surfaces of the upper insulating layers 52. The upper insulating layer 52 that has been subjected to roughening treatment has a surface with an average roughness Ra of about 0.6 µm. While the surface of the lower insulating layer 51 is not subjected to the roughing treatment, the surface of the lower insulating layer 51 has an average roughness Ra of about 0.2 µm in case of performing roughening treatment similar to that on the upper insulating layer 52 on this surface.

As illustrated in Fig. 1 and similar figure, the conductor layers 41 and 42 as wiring are buried only in the lower insulating layers 51 among the upper insulating layers 52 and the lower insulating layers 51 that constitute the resin insulating layers 33 to 36. In other words, the thickness of the conductor layers 41 and 42 are thinner than the thickness of the lower insulating layer 51. Therefore, there is a relationship where the top surfaces of the conductor layers 41 and 42 do not reach the inferior surfaces of the respective upper insulating layers 52. Regarding the upper insulating layer 52 and the lower insulating layer 51, the latter layer has a larger thickness. Accordingly, the via conductor 44 has a larger contact area with the lower insulating layer 51 than a contact area with the upper insulating layer 52. In this embodiment, the upper insulating layer 52 has a thickness equal to or less than 1/3 of the thickness of the lower insulating layer 51. The contact area with the lower insulating layer 51 is three times or more larger than the contact area with the upper insulating layer 52.

Next, a description will be given of a method for manufacturing the multilayer wiring board 10 according to this embodiment.

First, a copper-clad laminate is prepared. In the copper-clad laminate, copper foils are pasted on both surfaces of a base material made of glass epoxy. Subsequently, a drilling machine is used to perform drilling processing such that a penetration hole 15 penetrating the front and rear surfaces of the copper-clad laminate is preliminarily formed in a predetermined position. Subsequently, electroless copper plating and electrolytic copper plating are performed on the inner surface of the penetration hole 15 of the copper-clad laminate, so as to form the through-hole conductor 16 inside of the penetration hole 15.

Subsequently, the void portion of the through-hole conductor 16 is plugged with insulating resin material (epoxy resin), so as to form the blocking body 17. Furthermore, the copper foils of the copper-clad laminate and copper plating layers formed on the copper foils are patterned by, for example, a subtractive method. As a result, as illustrated in Fig. 3, the core substrate 11 where the through-hole conductor 16 and the conductor layer 41 are formed is obtained.

Subsequently, a build-up step is performed so as to form the first build-up layer 31 on the core main surface 12 of the core substrate 11 and also to form the second build-up layer 32 on the core reverse surface 13 of the core substrate 11.

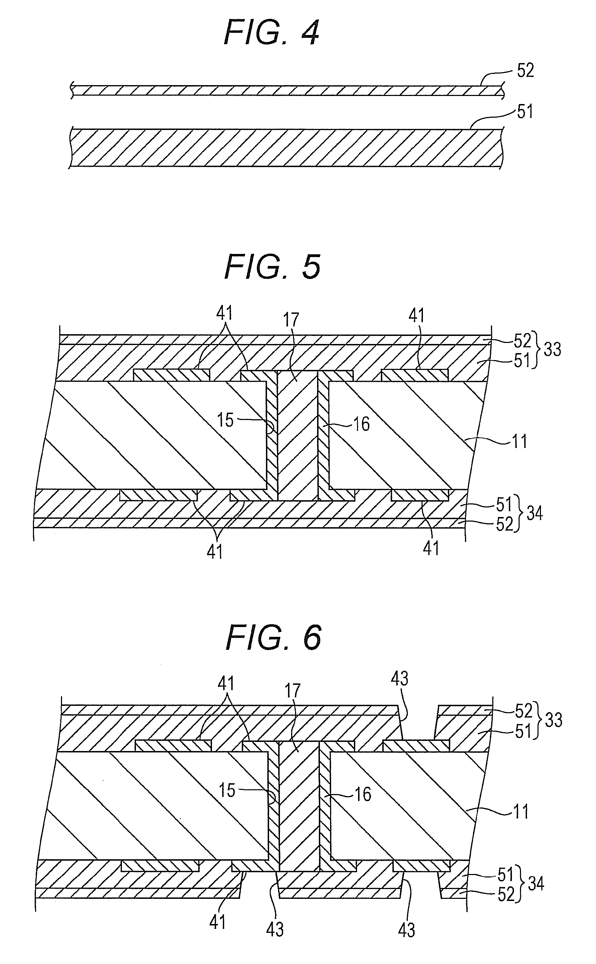

For details, as illustrated in Fig. 4, a build-up material to form the lower insulating layer 51 and a build-up material to form the upper insulating layer 52 for each of the resin insulating layers 33 to 36 are prepared (a preparation step). The build-up material of the lower insulating layer 51 is a sheet-shaped build-up material constituted such that the epoxy resin contains the silica filler 55 and the glass cloth 56. The build-up material of the upper insulating layer 52 is a sheet-shaped build-up material constituted such that the epoxy resin contains the silica filler 54 alone as the inorganic material.

Subsequently, the build-up materials of the lower insulating layer 51 are disposed on the core main surface 12 and the core reverse surface 13 of the core substrate 11. The build-up materials of the upper insulating layer 52 are laminated on these lower insulating layers 51 (a lamination step). Accordingly, the resin insulating layers 33 and 34 each formed of the lower insulating layer 51 and the upper insulating layer 52 are disposed on the core main surface 12 and the core reverse surface 13 of the core substrate 11 so as to attach the resin insulating layers 33 and 34 (see Fig. 5).

Subsequently, for example, a laser drilling process is performed by using CO₂ laser so as to form the via holes 43 in predetermined positions on the resin insulating layers 33 and 34 (see Fig. 6). Next, a desmear step (a roughing step) is performed for removing smear inside of each via hole 43 by using an etching solution such as a potassium permanganate solution. In this desmear step, roughening treatment is performed on the inner wall surface of the via hole 43 and the surface of the upper insulating layer 52, so as to roughen these surfaces. As the desmear step, for example, plasma ashing treatment may be performed using O₂ plasma other than the process using the etching solution.

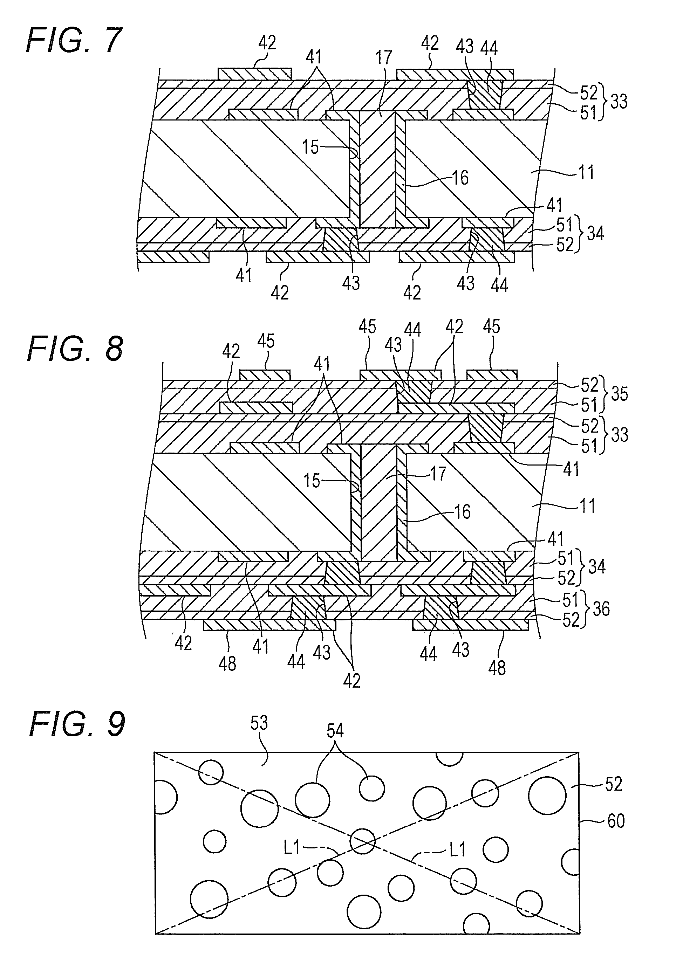

After the desmear step, in accordance with a conventionally-known method, the electroless copper plating and the electrolytic copper plating are performed so as to form the via conductor 44 inside of each via hole 43. Furthermore, the etching with a conventionally-known method (for example, a semi-additive method) is performed to form the patterns of the conductor layers 42 on the resin insulating layers 33 and 34 as illustrated in Fig. 7 (a conductor-layer forming step).

The other resin insulating layers 35 and 36 and the conductor layers 42 are also formed with a method similar to that for the resin insulating layers 33 and 34 and the conductor layers 42 described above, and laminated on the resin insulating layers 33 and 34. Here, as the conductor layer 42 on the resin insulating layer 35, the plurality of terminal pads 45 is formed. As the conductor layer 42 on the resin insulating layer 36, the plurality of BGA pads 48 is formed (see Fig. 8).

Subsequently, photosensitive epoxy resin is applied over the resin insulating layers 35 and 36 and hardened, so as to form the solder resists 37 and 38. Subsequently, exposure and development are performed in a state where a predetermined mask is disposed so as to form the patterns of the opening portions 46 and 49 in the solder resists 37 and 38. The multilayer wiring board 10 illustrated in Fig. 1 is manufactured through the above-described manufacturing processes.

Regarding a completed product of the above-described multilayer wiring board 10, a description will be given of a method for obtaining the volume proportion of the inorganic material contained in the lower insulating layer 51 and the upper insulating layer 52 below. Specifically, the multilayer wiring board 10 is cut along its thickness direction. Subsequently, the cross-sections of the lower insulating layer 51 and the upper insulating layer 52 are taken through an electronic microscope (SEM). The volume proportion of the inorganic material (the silica fillers 54 and 55 and the glass cloth 56) is estimated based on the SEM photograph of each cross-section of the insulating layers 51 and 52. Here, for example, in a SEM photograph 60 of the upper insulating layer 52 (see Fig. 9), diagonal lines L1 are drawn. Subsequently, the length of the silica filler 54 lying on the diagonal lines L1 (the distance that is the summation of the respective widths of the silica fillers 54 overlapping the diagonal lines L1) is measured. The proportion of this length is obtained as the volume proportion of the silica filler 54. Similarly, regarding the SEM photograph of the lower insulating layer 51, the length of the silica filler 55 and the glass cloth 56 lying on the diagonal lines L1 are measured. The proportion of this length is obtained as the volume proportion of the silica filler 55 and the glass cloth 56.

The inventor confirmed that the volume proportion of the silica filler 54 occupying the upper insulating layer 52 was lower than the volume proportion of the silica filler 55 and the glass cloth 56 occupying the lower insulating layer 51 using the above-described measurement method regarding the actually manufactured multilayer wiring board 10.

Accordingly, this embodiment provides the following effects.
(1) In the multilayer wiring board 10 according to this embodiment, the upper insulating layers 52 that constitute the resin insulating layers 33 to 36 each have a low volume proportion of the silica filler 54. This ensures a comparatively large surface roughness of the upper insulating layer 52 after the desmear step. Consequently, this ensures sufficient adhesion strength of the conductor layer 42 on the upper insulating layer 52. The lower insulating layers 51 that constitute the resin insulating layers 33 to 36 are each formed thicker than the upper insulating layer 52, and each have a high volume proportion of the inorganic material that contains the silica filler 55 and the glass cloth 56. This ensures reduced thermal expansion coefficients of the resin insulating layers 33 to 36 so as to manufacture the multilayer wiring board 10 with little warpage and excellent connection reliability.
(2) In the multilayer wiring board 10 according to this embodiment, the lower insulating layer 51 and the upper insulating layer 52 both contain the silica fillers 54 and 55. The average grain diameter of the silica filler 54 in the upper insulating layer 52 is larger than the average grain diameter of the silica filler 55 in the lower insulating layer 51. This ensures a large surface roughness of the upper insulating layer 52 after the desmear step. Decreasing the grain diameter of the granular inorganic material in the lower insulating layer 51 allows the lower insulating layer 51 to contain an increased amount of the silica filler 55. Furthermore, the lower insulating layer 51 is constituted to contain the glass cloth 56 in addition to the silica filler 55. This decreases the thermal expansion coefficient.
(3) In the multilayer wiring board 10 according to this embodiment, the lower insulating layer 51 includes the glass cloth 56 disposed approximately in the center of the lower insulating layer 51 in the thickness direction. Accordingly, the lower insulating layer 51 reliably contains the glass cloth 56 without exposure of the glass cloth 56 from the surface of the lower insulating layer 51. Containing the glass cloth 56 in the lower insulating layer 51 ensures sufficient strengths of the resin insulating layers 33 to 36.
(4) In the multilayer wiring board 10 according to this embodiment, the average grain diameter of the silica filler 54 in the upper insulating layer 52 is 1.0 µm that is sufficiently smaller than the thickness of the upper insulating layer 52. Accordingly, the upper insulating layer 52 reliably contains the silica filler 54.
(5) In the multilayer wiring board 10 according to this embodiment, the conductor layers 41 and 42 are buried only in the lower insulating layers 51 among the upper insulating layers 52 and the lower insulating layers 51 that constitute the resin insulating layers 33 to 36. Accordingly, the conductor layers 41 and 42 are buried only in the lower insulating layers 51 with the smaller thermal expansion coefficient than that of the upper insulating layer 52. This relieves the stress generated by the difference in thermal expansion coefficient between the conductor layers 41 and 42 and the resin insulating layers 33 to 36. Accordingly, the multilayer wiring board 10 with little warpage and excellent connection reliability can be more reliably obtained.
(6) The multilayer wiring board 10 according to this embodiment further includes the via conductors 44 formed by penetrating the resin insulating layers 33 to 36. The via conductors 44 each have the larger contact area with the lower insulating layer 51 than the contact area with the upper insulating layer 52. This ensures an increased contact area between the via conductor 44 and the lower insulating layer 51, which has the smaller thermal expansion coefficient than that of the upper insulating layer 52, thus allowing to relieve the stress on the inner wall surface of the via hole 43. Accordingly, the multilayer wiring board 10 with little warpage and excellent connection reliability can be more reliably obtained.

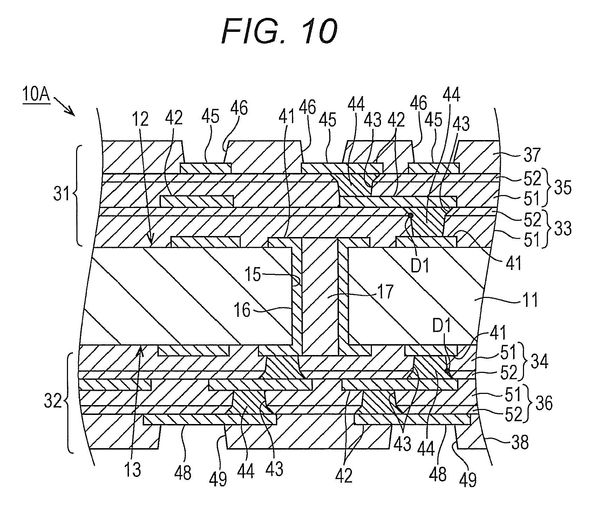

The embodiment of the present invention may be modified as follows.
- While in the above-described embodiment, the lower insulating layers 51 that constitute the resin insulating layers 33 to 36 each contain the silica filler 55 and the glass cloth 56 in the resin insulating material 53, the lower insulating layers 51 may each contain the silica filler 55 alone without containing the glass cloth 56. While the upper insulating layers 52, which constitute the resin insulating layers 33 to 36, each contain the silica filler 54 with the larger average grain diameter than that of the silica filler 55 in the lower insulating layer 51, the upper insulating layers 52 may each contain a silica filler with the same average grain diameter as that of the silica filler 55. In this case, as the silica filler, a filler with an average grain diameter equal to or less than 1 µm is contained in the lower insulating layer 51 and the upper insulating layer 52. The respective resin insulating layers 33 to 36 are each formed to have a larger filler content occupying the lower insulating layer 51 than that of the upper insulating layer 52. This also decreases the thermal expansion coefficient of the overall insulating layer and ensures reduced warpage of the multilayer wiring board 10. Changing the average grain diameter of the silica filler contained in the upper insulating layer 52 allows adjusting the surface roughness of the upper insulating layer 52 after the desmear step. This consequently ensures the fan-pitch wiring pattern for each conductor layer 42 on the upper insulating layer 52.
- While in the above-described embodiment, all the resin insulating layers 33 to 36 that constitute the multilayer wiring board 10 are insulating layers in the two-layer construction formed of the lower insulating layer 51 and the upper insulating layer 52, the multilayer wiring board that includes a resin insulating layer in a single layer construction may be constituted.
- In the method for manufacturing the multilayer wiring board 10 according to the above-described embodiment, the build-up material of the lower insulating layer 51 and the build-up material of the upper insulating layer 52 are separately laminated. This, however, should not be construed in a limiting sense. Specifically, the resin insulating layers 33 and 34 in a two-layer construction where the build-up material to form the lower insulating layer 51 and the build-up material to form the upper insulating layer 52 are preliminarily laminated may be used, and this multilayer wiring board 10 may be manufactured by disposing the resin insulating layers 33 and 34 on the core substrate 11.
- While in the above-described embodiment, the present invention is embodied in the multilayer wiring board 10 with the core substrate 11, the present invention may be embodied in a coreless wiring board without the core substrate 11.
- The form of the multilayer wiring board 10 in the above-described embodiment is not limited only to ball grid array (BGA). For example, the present invention may be applied to a wiring board in the form of pin grid array (PGA), land grid array (LGA), or similar package.
- In the multilayer wiring board 10 according to the above-described embodiment, the taper angle in the area penetrating the upper insulating layer 52 in the via hole 43 is the same as the taper angle in the area penetrating the lower insulating layer 51 in the via hole 43. Therefore, there is no specific step on the inner wall surface of the via hole 43 positioned at the boundary between the upper insulating layer 52 and the lower insulating layer 51. Instead, for example, like a multilayer wiring board 10A in another embodiment illustrated in Fig. 10, the taper angle in the area penetrating the upper insulating layer 52 in the via hole 43 may be designed to be larger than the taper angle in the area penetrating the lower insulating layer 51 in the via hole 43. Accordingly, a step D1 may be formed on the inner wall surface of the via hole 43 positioned at the boundary between the upper insulating layer 52 and the lower insulating layer 51. Accordingly, the resin insulating layers 33 to 36 each have a large contact area with the via conductor 44, compared with the above-described embodiment. This makes it easy to relieve the stress on the inner wall surface of the via hole 43. Accordingly, the multilayer wiring board 10A with little warpage and excellent connection reliability can be more reliably obtained.

Next, some of the technical ideas that the embodiment described above implements, are enumerated below.
(1) The multilayer wiring board in Means 1 has a feature that the inorganic material is an insulating inorganic material.
(2) The multilayer wiring board in Means 1 has a feature that a fiber-like inorganic material is disposed approximately in the center of the lower insulating layer in the thickness direction.
(3) The multilayer wiring board in Means 1 has a feature that the lower insulating layer is constituted to contain a silica filler and a glass cloth as the inorganic material, and that the upper insulating layer is constituted to contain the silica filler alone as the inorganic material.
(4) The multilayer wiring board in the technical idea (3) has a feature that the lower insulating layer contains the silica filler in a proportion of 60 weight% or more, and that the upper insulating layer contains the silica filler in a proportion of 45 weight% or less.
(5) The multilayer wiring board in the technical idea (3) has a feature that the lower insulating layer contains the inorganic material including the silica filler and the glass cloth in a proportion of 80 weight% or more.
(6) The multilayer wiring board in Means 1 has a feature that the lower insulating layer has a thermal expansion coefficient less than 25 ppm/°C, and that the upper insulating layer has a thermal expansion coefficient of 35 ppm/°C or more.
(7) The multilayer wiring board in Means 1 has a feature that a surface of the upper insulating layer is a rough surface.
(8) The multilayer wiring board in Means 1 has a feature that the upper insulating layer and the lower insulating layer are each formed by using a sheet-shaped build-up material.
(9) The multilayer wiring board in Means 1 has a feature that the upper insulating layer has a thickness equal to or less than 1/3 of a thickness of the lower insulating layer.
(10) The multilayer wiring board in Means 1 has a feature that the upper insulating layer and the lower insulating layer both contain a granular inorganic material, and that the granular inorganic material in the upper insulating layer has an average grain diameter smaller than a thickness of the upper insulating layer.
(11) The multilayer wiring board in Means 1 has a feature that the upper insulating layer has a thickness equal to or more than 5 µm and less than or equal to 10 µm, and that the lower insulating layer has a thickness equal to or more than 20 µm.
(12) The multilayer wiring board in Means 1 has a feature that the upper insulating layer and the lower insulating layer both contain a granular inorganic material, the upper insulating layer has a thickness equal to or more than 5 µm and less than or equal to 10 µm, the lower insulating layer has a thickness equal to or more than 20 µm, and the granular inorganic material in the upper insulating layer has an average grain diameter equal to or less than 1 µm.
(13) The multilayer wiring board in Means 1 has a feature that the upper insulating layer and the lower insulating layer both contain a granular inorganic material, the granular inorganic material in the upper insulating layer has an average grain diameter equal to or more than 1 µm, and the granular inorganic material in the lower insulating layer has an average grain diameter equal to or less than 0.5 µm.

### DESCRIPTION OF REFERENCE SIGNS

- 10, 10A: Multilayer wiring board
- 33 to 36: Resin insulating layer
- 42: Conductor layer
- 44: Via conductor
- 51: Lower insulating layer
- 52: Upper insulating layer
- 53: Resin insulating material
- 54, 55: Silica filler as granular inorganic material
- 56: Glass cloth as fiber-like inorganic material
- D1: Step

## Claims

1. A multilayer wiring board with a multilayered build-up construction where a plurality of resin insulating layers and a plurality of conductor layers are alternately laminated, wherein
at least one resin insulating layer among the plurality of resin insulating layers is formed of a lower insulating layer and an upper insulating layer, the upper insulating layer being disposed on the lower insulating layer, the upper insulating layer having a surface on which the conductor layer is formed,
the upper insulating layer and the lower insulating layer each contain an inorganic material in a resin insulating material,
the upper insulating layer is formed thinner than the lower insulating layer, and the inorganic material occupying the upper insulating layer has a lower volume proportion than a volume proportion of the inorganic material occupying the lower insulating layer.

2. The multilayer wiring board according to claim 1, wherein
the upper insulating layer and the lower insulating layer both contain a granular inorganic material, and the granular inorganic material in the upper insulating layer has an average grain diameter that is the same as or larger than an average grain diameter of the granular inorganic material in the lower insulating layer.

3. The multilayer wiring board according to claim 1 or 2, wherein
the lower insulating layer has a smaller thermal expansion coefficient than a thermal expansion coefficient of the upper insulating layer.

4. The multilayer wiring board according to any one of claims 1 to 3, wherein
the lower insulating layer contains both a granular inorganic material and a fiber-like inorganic material as the inorganic material.

5. The multilayer wiring board according to any one of claims 1 to 3, wherein
the lower insulating layer contains both a granular inorganic material and a fiber-like inorganic material as the inorganic material while the upper insulating layer contains a granular inorganic material alone as the inorganic material.

6. The multilayer wiring board according to claim 3, wherein
the conductor layer is buried only in the lower insulating layer among the upper insulating layer and the lower insulating layer that constitute the resin insulating layers.

7. The multilayer wiring board according to claim 3, further comprising a via conductor formed by penetrating the resin insulating layer, wherein
the via conductor has a larger contact area with the lower insulating layer than a contact area with the upper insulating layer.

8. A method for manufacturing a multilayer wiring board with a multilayered build-up construction where a plurality of resin insulating layers and a plurality of conductor layers are alternately laminated, the method comprising:
a preparation step of preparing a lower insulating layer and an upper insulating layer, the lower insulating layer and the upper insulating layer forming at least one resin insulating layer among the plurality of resin insulating layers;
a lamination step of laminating the upper insulating layer on the lower insulating layer;
a roughening step of performing roughening treatment on a surface of the upper insulating layer; and
a conductor-layer forming step of forming the conductor layer on the roughened surface of the upper insulating layer, wherein
the upper insulating layer and the lower insulating layer contain an inorganic material in a resin insulating material,
the inorganic material occupying the upper insulating layer has a lower volume proportion than a volume proportion of the inorganic material occupying the lower insulating layer.

## Amended claims

### Amended claims under Art. 19.1 PCT

1. (Amended) A multilayer wiring board with a multilayered build-up construction where a plurality of resin insulating layers and a plurality of conductor layers are alternately laminated, wherein
at least one resin insulating layer among the plurality of resin insulating layers is formed of a lower insulating layer and an upper insulating layer, the upper insulating layer being disposed on the lower insulating layer, the upper insulating layer having a surface on which the conductor layer is formed,
the upper insulating layer and the lower insulating layer each contain an inorganic material in a resin insulating material,
the upper insulating layer is formed thinner than the lower insulating layer,
the inorganic material occupying the upper insulating layer has a lower volume proportion than a volume proportion of the inorganic material occupying the lower insulating layer, and
the lower insulating layer contains both a granular inorganic material and a fiber-like inorganic material as the inorganic material.

2. The multilayer wiring board according to claim 1, wherein
the upper insulating layer and the lower insulating layer both contain a granular inorganic material, and the granular inorganic material in the upper insulating layer has an average grain diameter that is the same as or larger than an average grain diameter of the granular inorganic material in the lower insulating layer.

3. The multilayer wiring board according to claim 1 or 2, wherein
the lower insulating layer has a smaller thermal expansion coefficient than a thermal expansion coefficient of the upper insulating layer.

4. (Cancelled)

5. (Amended) The multilayer wiring board according to any one of claims 1 to 3, wherein
the upper insulating layer contains a granular inorganic material alone as the inorganic material.

6. The multilayer wiring board according to claim 3, wherein
the conductor layer is buried only in the lower insulating layer among the upper insulating layer and the lower insulating layer that constitute the resin insulating layers.

7. The multilayer wiring board according to claim 3, further comprising
a via conductor formed by penetrating the resin insulating layer, wherein
the via conductor has a larger contact area with the lower insulating layer than a contact area with the upper insulating layer.

8. A method for manufacturing a multilayer wiring board with a multilayered build-up construction where a plurality of resin insulating layers and a plurality of conductor layers are alternately laminated, the method comprising:
a preparation step of preparing a lower insulating layer and an upper insulating layer, the lower insulating layer and the upper insulating layer forming at least one resin insulating layer among the plurality of resin insulating layers;
a lamination step of laminating the upper insulating layer on the lower insulating layer;
a roughening step of performing roughening treatment on a surface of the upper insulating layer; and
a conductor-layer forming step of forming the conductor layer on the roughened surface of the upper insulating layer, wherein
the upper insulating layer and the lower insulating layer contain an inorganic material in a resin insulating material,
the inorganic material occupying the upper insulating layer has a lower volume proportion than a volume proportion of the inorganic material occupying the lower insulating layer.
